# EUROPEAN PATENT APPLICATION

(11) **EP 4 708 364 A1**
(43) Date of publication of application: **11.03.2026**
(21) Application number: 23942165.4
(22) Date of filing: 30.11.2023
(51) Int. Cl.: H01L 31/0224, H01L 31/0747, H01L 31/05

(54) **BUSBAR-FREE HETEROJUNCTION SOLAR CELL AND ASSEMBLY THEREOF**

(30) Priority: 21.06.2023 CN 202321591766 U
(71) Applicant: Ja Solar Technology Yangzhou Co., Ltd., Yangzhou, Jiangsu 225131 (CN)
(72) Inventor: ZHANG, Junbing, Yangzhou, Jiangsu 225131 (CN); CHEN, Bin, Yangzhou, Jiangsu 225131 (CN); LIU, Shuhua, Yangzhou, Jiangsu 225131 (CN)
(74) Representative: Sun, Yiming
(86) International application number: PCT/CN2023/135328
(87) International publication number: WO 2024/259899

(57) **Abstract**

A busbar-free heterojunction solar cell comprises a cell body and a plurality of parallel finger grid electrodes provided on the front and back sides of the cell body, wherein each finger grid electrode comprises a plurality of first finger grid electrodes, a second finger grid electrode is provided between two adjacent first finger grid electrodes, both ends of the second finger grid electrode are respectively in lap-joint with the two adjacent first finger grid electrodes, and a welding positioning groove is formed in a middle portion of the second finger grid electrode. The structure of the solar cell can not only ensure good conductive performance of finger grid electrodes but also take into account good welding performance of the finger grid electrodes.

## Description

### CROSS-REFERENCE TO RELATED APPLICATIONS

The present application claims the priority of the Chinese patent application No. 202321591766.2 filed on June 21, 2023, the disclosure of which is hereby incorporated by reference in its entirety.

### TECHNICAL FIELD

The present disclosure relates to the technical field of solar cell module, and, in particular, to a busbar-free heterojunction solar cell and an module thereof.

### BACKGROUND

The solar cell, which is a photoelectric conversion semiconductor device, is usually a homojunction or heterojunction diode structure formed by combining one or more semiconductor materials that absorb sunlight and convert it into electricity. The semiconductor materials absorb ambient sunlight to generate carriers of electrons and holes, which are usually called photo-generated carriers, and after separation by a built-in electric field of the diode, the electrons and holes gather in n-type and p-type semiconductor regions, respectively, to form an electric potential. In order to transport the electrons and holes effectively to an external circuit, metal electrodes are usually fabricated on a front surface (first light-receiving surface) and a back surface (second light-receiving surface), and the metal electrodes form good electrical contact with the semiconductor materials and transport the photo-generated carriers effectively to the external circuit.

The heterojunction (HJT) cell is obtained mainly by depositing an intrinsic α-Si:H layer on the front/back side of an n-type silicon wafer, then preparing a p-type α-Si:H layer and an n-type α-Si:H layer respectively, and then using a low-temperature silver paste for screen printing, drying and curing. In actual production, a transparent conductive oxide film (TCO) can also be deposited on the surface of the silicon wafer before a metallization process is carried out. The above-mentioned heterojunction solar cell, which is one of new high-efficiency cell technologies, combines the advantages of a monocrystalline silicon solar cell and an amorphous silicon solar cell, and has the characteristics of a low preparation process temperature, a high conversion efficiency, and good high-temperature performance. Since the heterojunction solar cell has a small temperature degradation coefficient and generates electricity on both sides, it has great market potential and has become a research and breakthrough focus in the industry.

The photovoltaic industry has developed rapidly under the energy crisis, and the key to further promoting photovoltaic applications is to improve the photoelectric conversion efficiency of solar cells and reduce the production cost of the cells.

The multi-busbar cell and module technology involves providing a plurality of large-area welding points on busbar and designing connection lines outside the welding points as thin lines close to the finger grid lines. This mode can reduce the silver consumption and the shading of the light-receiving surface by the busbar. However, the silver paste consumption is still very high, that is, the silver paste consumption of a single M10 (182 mm*182 mm) sized heterojunction solar cell is 140 mg or more, which is still higher than those of conventional crystalline silicon solar cells. Meanwhile, large-area grid lines increase the shading area. The structure and process of the metal electrodes need to be further improved to reduce the high cost caused by high silver consumption and the efficiency loss resulting from light shading. In order to reduce the shading of the cell surface by the grid lines and further lower the electrode manufacturing cost, the busbar-free cell technology has become a research hotspot.

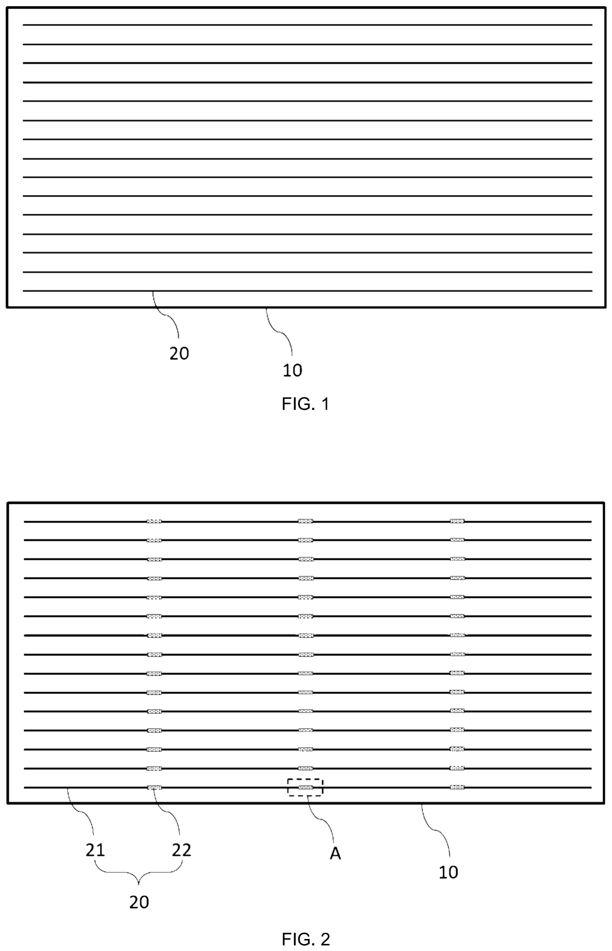

For the current busbar-free cell, the busbars on the front and back sides of the solar cell are directly removed (as shown in FIG. 1). However, due to small contact points between the welding band and the secondary grid lines, it is easy to cause abnormal conditions such as welding deviation, cold welding (unqualified welding tension) or welding failure. Meanwhile, since the finger grid lines focus on current collection, the selection of slurry will focus on the selection of conductive performance, which will reduce the adhesion force between the slurry, the surface of the cell body and the interconnection band. This problem is more serious in the heterojunction solar cell made by a low-temperature process.

### SUMMARY

In view of the above analysis, the present disclosure aims to provide a busbar-free heterojunction solar cell and a module thereof, to solve the problem of poor welding performance of the existing busbar-free heterojunction solar cells.

The objects of the present disclosure are mainly accomplished by the following technical solutions:
A busbar-free heterojunction solar cell comprises a cell body and a plurality of parallel finger grid electrodes provided on the front and back sides of the cell body, wherein each finger grid electrode comprises a plurality of first finger grid electrodes distributed discontinuously in a straight line, a second finger grid electrode is provided between two adjacent first finger grid electrodes, both ends of the second finger grid electrode are respectively in lap-joint with the two adjacent first finger grid electrodes, and a welding positioning groove is formed in a middle portion of the second finger grid electrode.

Further, the first finger grid electrode and the second finger grid electrode use different metal slurries.

Further, the first finger grid electrode has better conductive performance than the second finger grid electrode. Further, an adhesion force between the second finger grid electrode and the cell body is greater than an adhesion force between the first finger grid electrode and the cell body.

Further, a width of the second finger grid electrode is not less than a width of the first finger grid electrode.

Further, a distance between the two adjacent first finger grid electrodes is 0.1 mm to 3.0 mm. Further, a lap-joint length between the first finger grid electrode and the second finger grid electrode is 0.01 mm to 0.1 mm.

Further, the cell body comprises a silicon substrate, a first intrinsic silicon-containing film, a first conductive type doped silicon-containing film and a first transparent conductive film provided on a front side of the silicon substrate, and a second intrinsic silicon-containing film, a second conductive type doped silicon-containing film and a second transparent conductive film provided on a back side of the silicon substrate.

A busbar-free heterojunction solar cell module comprises a plurality of solar cells according to the above technical solutions and an interconnection band connecting the plurality of solar cells.

Further, a connection point between the interconnection band and the finger grid electrode is located in the welding positioning groove, and the interconnection band is welded to the second finger grid electrode. The present disclosure can achieve at least one of the following advantageous effects:
(1) The solar cell of the present disclosure utilizes two printing steps to respectively print a first finger grid having good conductive performance and a second finger grid having good welding performance and adhesion force for connecting the first finger grid, and this structure can not only ensure good conductive performance of finger grid electrodes but also take into account good welding performance of the finger grid electrodes.
(2) The solar cell of the present disclosure uses a welding positioning groove formed by a height difference structure generated by stacking of the first finger grid and the second finger grid to prevent the occurrence of welding and lamination offsets, thereby further improving the welding performance of the busbar-free heterojunction cell and the yield rate of the cell module.

In the present disclosure, the above various technical solutions can also be combined with each other to achieve more preferred combination solutions. Other features and advantages of the present disclosure will be set forth later in the Description, and some advantages may become apparent from the Description or may be learned through the implementation of the present disclosure. The objects and other advantages of the present disclosure may be realized and obtained through contents particularly pointed out in the Description and Drawings.

### BRIEF DESCRIPTION OF DRAWINGS

The drawings are only for the purpose of illustrating specific embodiments and are not regarded as limitations to the present disclosure. Throughout the drawings, the same reference signs indicate the same components.
FIG. 1 is a schematic structural diagram of a busbar-free heterojunction solar cell in the existing art;
FIG. 2 is a schematic structural diagram of a busbar-free heterojunction solar cell according to an embodiment of the present disclosure;
FIG. 3 is a partial enlarged view of Part A in FIG. 2;
FIG. 4 is a front view of FIG. 3;
FIG. 5 is a schematic structural diagram of a busbar-free heterojunction solar cell module according to an embodiment of the present disclosure;
FIG. 6 is a partial enlarged sectional schematic diagram of Part B in FIG. 5.

Reference Signs:
10-Cell Body, 20-Finger Grid Electrode, 21-First Finger Grid Electrode, 22-Second Finger Grid Electrode, 30-Welding Positioning Groove, 40-Interconnection Band

### DETAILED DESCRIPTION

Hereinafter, preferred embodiments of the present disclosure are described in detail in conjunction with the drawings, wherein the drawings, which constitute a part of the present disclosure and are used together with the embodiments of the present disclosure to explain the principles of the present disclosure, are not used to limit the scope of the present disclosure.

As shown in FIG. 1, the busbars on the front and back sides of the solar cells are directly removed from the existing busbar-free heterojunction cells, and the interconnection band and the secondary grid lines are welded to connect multiple cells to form a cell module. However, since the secondary grid lines are relatively thin and the contact points between the interconnection band and the secondary grid lines are small, abnormal conditions such as welding deviation, cold welding or welding failure are prone to occur, and the poor welding performance of the cells results in a low yield rate of the cell module.

### Embodiment 1

In view of the above analysis, an embodiment of the present disclosure, as shown in FIG. 2, discloses a busbar-free heterojunction solar cell, comprising a cell body 10 and a plurality of parallel finger grid electrodes 20 provided on the front and back sides of the cell body 10, wherein each finger grid electrode 20 comprises a plurality of first finger grid electrodes 21 distributed discontinuously in a straight line, a second finger grid electrode 22 is provided between two adjacent first finger grid electrodes 21, the first finger grid electrode 21 and the second finger grid electrode 22 are respectively printed on the cell body 10 in two times, both ends of the second finger grid electrode 22 are respectively in lap-joint with the two adjacent first finger grid electrodes 21.

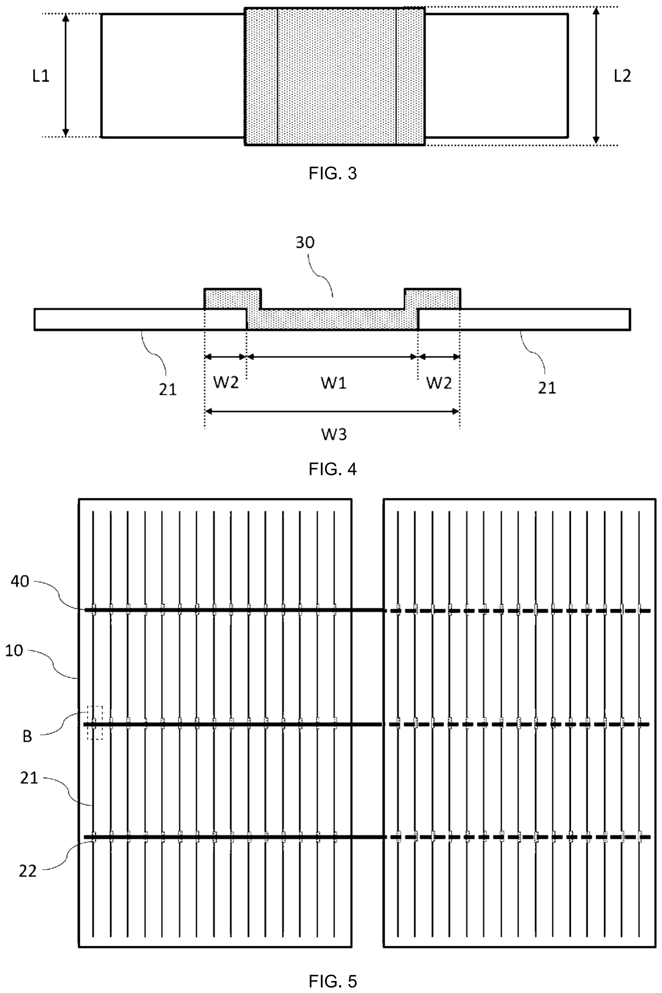

In the present embodiment, as shown in FIG. 4, since both ends of the second finger grid electrode 22 are respectively in lap-joint with the two adjacent first finger grid electrodes 21, both ends of the second finger grid electrode 22 in lap-joint with the first finger grid electrodes 21 are higher than the middle portion of the second finger grid electrode 22, a welding positioning groove 30 is formed in the middle portion of the second finger grid electrode 22, and the interconnection band 40 is disposed perpendicular to the finger grid electrodes 20 and is located in the welding positioning groove 30, thereby connecting the plurality of finger grid electrodes 20. In addition, the welding positioning groove 30 provides positioning and welding points for the interconnection band 40, preventing the occurrence of welding and lamination offsets, improving the welding performance of the busbar-free heterojunction solar cell, and thus increasing the yield rate of the cell module.

Further, as shown in FIG. 3, a width L2 of the second finger grid electrode 22 is not less than a width L1 of the first finger grid electrode 21, to ensure the reliability of the connections between the second finger grid electrode 22 and the first finger grid electrode 21 and between the second finger grid electrode 22 and the interconnection band 40.

Further, the first finger grid electrode 21 and the second finger grid electrode 22 use different metal slurries.

Further, an adhesion force between the second finger grid electrode 22 and the cell body 10 and/or the interconnection band 40 is greater than an adhesion force between the first finger grid electrode 21 and the cell body 10 and/or the interconnection band 40, the first finger grid electrode 21 has better conductive performance than the second finger grid electrode 22, and the first finger grid electrode 21 and the second finger grid electrode 22 are printed in two times, which can take into account the welding performance of the finger grid electrodes 20 while ensuring the good conductive performance of the finger grid electrodes 20.

Further, as shown in FIG. 4, a distance W1 between the two adjacent first finger grid electrodes 21 is 0.1 mm to 3.0 mm, and a lap-joint length W2 between the first finger grid electrode 21 and the second finger grid electrode 22 is 0.01 mm to 0.1 mm.

In the present embodiment, the cell body 10 comprises a silicon substrate, a first intrinsic silicon-containing film, a first conductive type doped silicon-containing film and a first transparent conductive film provided on a front side of the silicon substrate, and a second intrinsic silicon-containing film, a second conductive type doped silicon-containing film and a second transparent conductive film provided on a back side of the silicon substrate.

Further, the first intrinsic silicon-containing film and/or the second intrinsic silicon-containing film are/is a single layer with the same properties or a multilayer with different properties among thin film layers such as microcrystalline, nano, amorphous silicon, silicon oxide or silicon carbide, or a stacked or mixed silicon-containing film of several types thereof.

Preferably, the first intrinsic silicon-containing film and/or the second intrinsic silicon-containing film have/has a thickness of 1 to 50 nm.

Further, the second conductive type doped silicon-containing film and/or the first conductive type doped silicon-containing film are/is a single layer with the same properties or a multilayer with different properties among thin film layers such as microcrystalline, nano, amorphous silicon, silicon oxide or silicon carbide, or a stacked or mixed silicon-containing film of several types thereof.

Preferably, the second conductive type doped silicon-containing film and/or the first conductive type doped silicon-containing film have/has a thickness of 1 to 50 nm.

Further, the first transparent conductive film and/or the second transparent conductive film are/is a multilayer or stacked layer or a mixture of one or more doped metal oxides or nitrides.

Further, the metal oxide is one or more of indium oxide, tin oxide, zinc oxide, cadmium oxide or titanium oxide, the metal nitride is titanium nitride, and the doping element is one or more of indium, tin, calcium, aluminum, cadmium, zinc, cerium or fluorine.

Preferably, the first transparent conductive film and/or the second transparent conductive film have/has a thickness of 1 to 100 nm.

### Embodiment 2

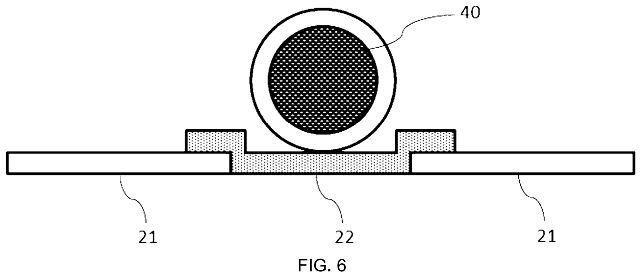

An embodiment of the present disclosure, as shown in FIG. 5, discloses a busbar-free heterojunction solar cell module, comprising a plurality of solar cells according to Embodiment 1 and an interconnection band 40 connecting the plurality of solar cells, wherein, as shown in FIG. 6, a connection point between the interconnection band 40 and the finger grid electrode 20 is located in the welding positioning groove 30, and the interconnection band 40 is welded to the second finger grid electrode 22, to connect the plurality of solar cells so as to form a solar cell module.

Compared with the existing art, the advantageous effects of the busbar-free heterojunction solar cell module provided by the present embodiment are substantially the same as those of the busbar-free heterojunction solar cell provided by Embodiment 1, and thus are not repeated here.

The above are only preferred embodiments of the present disclosure, but the scope of protection of the present disclosure is not limited thereto. Any changes or substitutions that can be easily conceived by those skilled in the art within the technical scope disclosed in the present disclosure should be covered within the scope of protection of the present disclosure.

## Claims

1. A busbar-free heterojunction solar cell, comprising a cell body (10) and a plurality of parallel finger grid electrodes (20) provided on the front and back sides of the cell body (10), wherein:
each finger grid electrode (20) comprises a plurality of first finger grid electrodes (21) distributed discontinuously in a straight line, a second finger grid electrode (22) is provided between two adjacent first finger grid electrodes (21), both ends of the second finger grid electrode (22) are respectively in lap-joint with the two adjacent first finger grid electrodes (21), and a welding positioning groove (30) is formed in a middle portion of the second finger grid electrode (22).

2. The busbar-free heterojunction solar cell according to claim 1, wherein:
the first finger grid electrode (21) and the second finger grid electrode (22) use different metal slurries.

3. The busbar-free heterojunction solar cell according to claim 2, wherein:
the first finger grid electrode (21) has better conductive performance than the second finger grid electrode (22).

4. The busbar-free heterojunction solar cell according to claim 2, wherein:
an adhesion force between the second finger grid electrode (22) and the cell body (10) is greater than an adhesion force between the first finger grid electrode (21) and the cell body (10).

5. The busbar-free heterojunction solar cell according to claim 1, wherein:
a width of the second finger grid electrode (22) is not less than a width of the first finger grid electrode (21).

6. The busbar-free heterojunction solar cell according to claim 1, wherein:
a distance between the two adjacent first finger grid electrodes (21) is 0.1 mm to 3.0 mm.

7. The busbar-free heterojunction solar cell according to claim 1, wherein:
a lap-joint length between the first finger grid electrode (21) and the second finger grid electrode (22) is 0.01 mm to 0.1 mm.

8. The busbar-free heterojunction solar cell according to any one of claims 1 to 7, wherein:
the cell body (10) comprises a silicon substrate, a first intrinsic silicon-containing film, a first conductive type doped silicon-containing film and a first transparent conductive film provided on a front side of the silicon substrate, and a second intrinsic silicon-containing film, a second conductive type doped silicon-containing film and a second transparent conductive film provided on a back side of the silicon substrate.

9. A busbar-free heterojunction solar cell module, comprising a plurality of solar cells according to any one of claims 1 to 8 and an interconnection band (40) connecting the plurality of solar cells.

10. The busbar-free heterojunction solar cell module according to claim 9, wherein:
a connection point between the interconnection band (40) and the finger grid electrode (20) is located in the welding positioning groove (30), and the interconnection band (40) is welded to the second finger grid electrode (22).
